# EUROPEAN PATENT SPECIFICATION

(11) **EP 4 089 748 B1**
(45) Date of publication and mention of the grant of the patent: **13.05.2026**
(21) Application number: 22170183.2
(22) Date of filing: 27.04.2022
(51) Int. Cl.: G02B 5/20, H10H 20/851

(54) **OPTICAL SUBSTRATE AND MANUFACTURING METHOD THEREOF**
OPTISCHES SUBSTRAT UND HERSTELLUNGSVERFAHREN DAFÜR
SUBSTRAT OPTIQUE ET SON PROCÉDÉ DE FABRICATION

(30) Priority: 11.05.2021 CN 202110512884
(43) Date of publication of application: 16.11.2022
(73) Proprietor: InnoLux Corporation, Chu-Nan, Miao-Li County 35053 (TW)
(72) Inventor: CHEN, Yi-An, 35053 Miao-Li County (TW); HUANG, Wan-Ling, 35053 Miao-Li County (TW); HSIEH, Tsau-Hua, 35053 Miao-Li County (TW)
(74) Representative: Becker, Eberhard

(56) References cited:
- EP-A1- 3 282 310
- CN-A- 111 505 866
- US-A1- 2011 038 070
- US-A1- 2014 339 495

## Description

### BACKGROUND

### Technical Field

The disclosure relates to an optical substrate and a manufacturing method thereof, and in particular, relates to an optical substrate and a manufacturing method thereof through which infiltration of water vapor may be reduced or reliability may be improved.

### Description of Related Art

Display panels have been widely applied in electronic devices such as mobile phones, televisions, monitors, tablet computers, car displays, wearable devices, and desktop computers. With the vigorous development of electronic products, the demand for improved display quality of the electronic products continues to grow, and as such, the electronic devices used for display aim to provide more reliable display effects.

CN 111505866 A relates to a display device including mutually independent sub-pixel areas, a light source that irradiates each sub-pixel area and a light control layer located on the light emitting side of the light source.

EP 3282310 Al relates to a color filter including a substrate, a first color conversion layer, a second color conversion layer, a barrier wall and a light blocking layer.

US 20111038070 A1 relates to a method for creating a color conversion layer using the ink jet method.

US 2014/339495 Al relates to a light emitting including a micro LED device bonded to a bottom electrode, a top electrode in electrical contact with the micro LED device and a wavelength conversion layer around the micro LED device.

### SUMMARY

The invention is set out in the appended set of claims. The following disclosure serves a better understanding of the present invention. The disclosure provides an optical substrate and a manufacturing method thereof through which infiltration of water vapor may be reduced or reliability may be improved.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1A to FIG. 1E are local cross-sectional schematic views of a manufacturing method of an optical substrate according to a first embodiment of the disclosure.
FIG. 2A to FIG. 2C are local cross-sectional schematic views of a manufacturing method of an optical substrate according to a second comparative example not falling under the claimed invention.
FIG. 3A to FIG. 3C are local cross-sectional schematic views of a manufacturing method of an optical substrate according to a third embodiment of the disclosure.
FIG. 4A to FIG. 4C are local cross-sectional schematic views of a manufacturing method of an optical substrate according to a fourth embodiment of the disclosure.

### DESCRIPTION OF THE EMBODIMENTS

The accompanying drawings are included together with the detailed description provided below to provide a further understanding of the disclosure. Note that in order to make the accompanying drawings to be more comprehensible to readers and for the sake of clarity of the accompanying drawings, only part of the electronic device is depicted in the accompanying drawings of the disclosure, and specific components in the drawings are not depicted according to actual scales. In addition, the numbers and sizes of the components in each drawing are provided for illustration only and are not used to limit the scope of the disclosure.

In the following specification and claims, the words "containing" and "including" are open-ended words and therefore should be interpreted as "containing but not limited to...".

It should be understood that when a component or a film layer is referred to as being "on" or "connected to" another component or film layer, it can be directly on the another component or film layer or be directly connected to the another component or film layer, or an inserted component or film layer may be provided therebetween (not a direct connection). In contrast, when the component is referred to as being "directly on" another component or film layer or "directly connected to" another component or film layer, an inserted component or film layer is not provided therebetween.

Although the terms "first", "second", "third"... may be used to describe various components, the components are not limited to these terms. These terms are only used to distinguish a single component from other components in the specification. The same terms may not be used in the claims, and the components in the claims may be replaced with first, second, third... according to the order declared by the components in the claims. Therefore, in the following description, the first component may be the second component in the claims.

In the text, the terms "about", "approximately", "substantially", and "roughly" usually mean within 10%, 5%, 3%, 2%, 1%, or 0.5% of a given value or range. The number given here is an approximate number, that is, the meanings of "about", "approximately", "substantially", and "roughly" may still be implied without specifying "about", "approximately", "substantially", and "roughly". In addition, the wordings "the range is from the first numerical value to the second numerical value" and "the range falls between the first numerical value and the second numerical value" mean that the range includes the first numerical value, the second numerical value, and other numerical values therebetween.

In some embodiments of the disclosure, regarding the words such as "connected", "interconnected", etc. referring to bonding and connection, unless specifically defined, these words mean that two structures are in direct contact or two structures are not in direct contact, and other structures are provided to be disposed between the two structures. The word for joining and connecting may also include the case where both structures are movable or both structures are fixed. In addition, the word "coupled" may include any direct or indirect electrical connection means.

In the disclosure, the length, width, thickness, height, area, or the distance or spacing between components may be measured by an optical microscope (OM), a scanning electron microscope (SEM), a film thickness profile measuring instrument (α-step), an elliptical thickness measuring instrument, or other suitable methods. To be specific, according to some embodiments, a scanning electron microscope may be used to obtain an image of the cross-sectional structure of the component to be measured, and to measure the width, thickness, height, or area of each component, or the distance or spacing between the components, but it is not limited thereto. In addition, a certain error may be provided between any two values or directions used for comparison.

The optical substrate provided by the disclosure may be applied to an electronic device such as a display device, an antenna device (e.g., a liquid crystal antenna), a sensing device, a light emitting device, a touch device, or a spliced device, but it is not limited thereto. The electronic device may include a bendable and flexible electronic device. The appearance of the electronic device may be rectangular, circular, polygonal, or a shape with curved edges, or other suitable shapes. The display device may include but not limited to a light emitting diode (LED), liquid crystal, fluorescence, phosphor, or quantum dot (QD) material, other suitable materials, or a combination of the foregoing, for example. The light emitting diode may include but not limited to an organic LED (OLED), an inorganic LED, a mini LED, a micro LED, or a QD LED (QDLED), other suitable materials, or a combination of the foregoing, for example. The display device may also include but not limited to a spliced display device, for example. The antenna device may be but not limited to a liquid crystal antenna, for example. The antenna device may include but not limited to an antenna spliced device, for example. Note that the electronic device may be any combination of the foregoing, but is not limited thereto. Besides, the appearance of the electronic device may be rectangular, circular, polygonal, or a shape with curved edges, or other suitable shapes. The electronic device may have a peripheral system such as a driving system, a control system, a light source system, a shelf system, etc., to support the display device, the antenna device, or the spliced device. Hereinafter, an optical substrate is provided herein to describe the content of the disclosure, but the disclosure is not limited thereto.

Descriptions of the disclosure are given with reference to the exemplary embodiments illustrated by the accompanying drawings. Wherever possible, the same reference numbers are used in the drawings and the description to refer to the same or like parts.

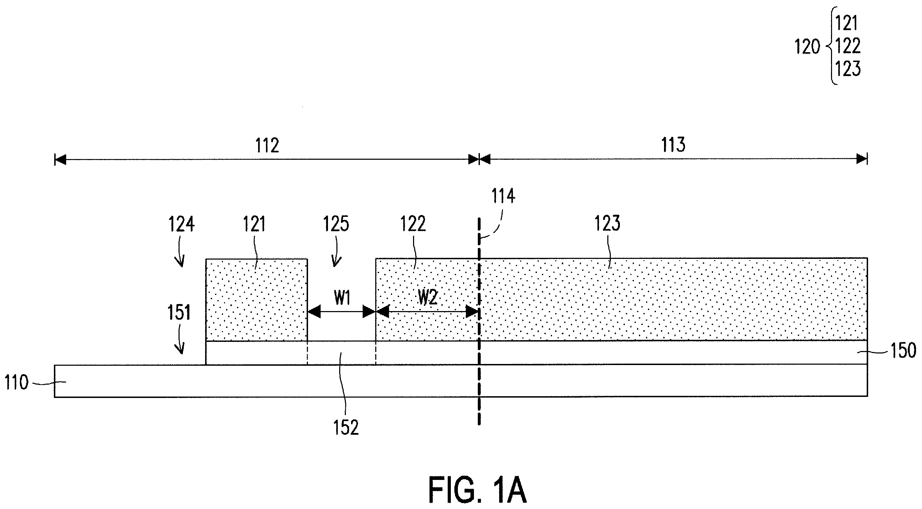

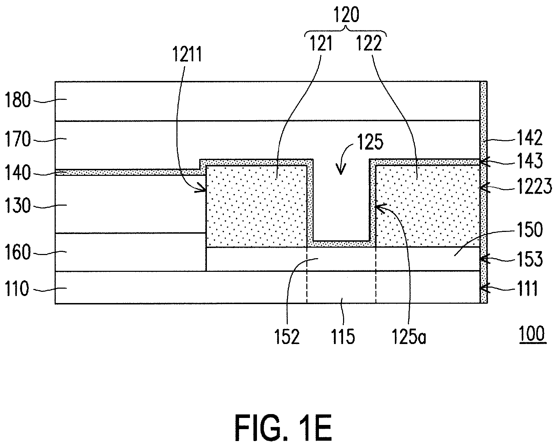

FIG. 1A to FIG. 1E are local cross-sectional schematic views of a manufacturing method of an optical substrate according to a first embodiment of the disclosure. With reference to FIG. 1E first, an optical substrate 100 provided by this embodiment includes a base layer 110, a bank layer 120, a wavelength conversion unit 130, and a first encapsulating layer 140. Herein, the bank layer 120 is disposed on the base layer 110, and the bank layer 120 includes a first bank portion 121 separated from an edge 111 of the base layer 110. The wavelength conversion unit 130 is disposed on the base layer 110, and the wavelength conversion unit 130 is adjacent to a side 1211 of the first bank portion 121 away from the edge 111. The first encapsulating layer 140 is disposed on the bank layer 120, the wavelength conversion unit 130, and a portion 115 of the base layer 110 not covered by the bank layer 120 and the wavelength conversion unit 130. In the disclosure, one component covering another component means that the two components overlap each other in a normal direction of the base layer 110.

A manufacturing method of the optical substrate 100 provided by this embodiment is described as follows.

With reference to FIG. 1A first, the base layer 110 is provided first. The base layer 110 may include an active region 112, a frame region 113, and a cutting line 114. The cutting line 114 is disposed at a junction between the active region 112 and the frame region 113. In this embodiment, the frame region 113 may be cut off in a subsequent cutting step, and the active region 112 is reserved as a part of the electronic device. In this embodiment, the base layer 110 may be, for example, a rigid substrate, a flexible substrate, or a combination of the foregoing. For instance, a material of the base layer 110 may include but not limited to glass, quartz, sapphire, ceramics, polycarbonate (PC), polyimide (PI), polyethylene terephthalate (PET), other suitable substrate materials, or a combination of the foregoing materials.

Next, before the bank layer 120 is formed on the base layer 110, a black matrix layer 150 is formed on the base layer 110 first. The black matrix layer 150 may include an opening 151 disposed in the active region 112. Herein, the opening 151 may expose a portion of the base layer 110. In some embodiments, a material of the black matrix layer 150 may include but not limited to a light-absorbing material such as black matrix (BM) resin or other suitable light-absorbing materials.

Next, the bank layer 120 is formed on the base layer 110. In this embodiment, the bank layer 120 is disposed on the black matrix layer 150, so that the black matrix layer 150 is disposed between the base layer 110 and the bank layer 120, and the bank layer 120 substantially overlaps with the black matrix layer 150 in the normal direction of the base layer 110. The bank layer 120 may include the first bank portion 121, a second bank portion 122, a third bank portion 123, a first opening 124, and a second opening 125. The first bank portion 121, the second bank portion 122, the first opening 124, and the second opening 125 are disposed in the active region 112, and the third bank portion 123 is disposed in the frame region 113. Herein, the cutting line 114 may also be disposed at a junction between the second bank portion 122 and the third bank portion 123.

To be specific, the first opening 124 is connected to and overlap with the opening 151 of the black matrix layer 150, so that the first opening 124 and the opening 151 may expose a portion of the base layer 110. The second opening 125 is disposed between the first bank portion 121 and the second bank portion 122. The second opening 125 exposes a portion 152 of the black matrix layer 150, so that the portion 152 of the black matrix layer 150 is not covered by the bank layer 120. The second opening 125 may be closer to the cutting line 114 of the base layer 110 than the first opening 124. Besides, a width W1 of the second opening 125 may be greater than or equal to 3 nm (i.e., W 1 ≧ 3 nm), for example, but it is not limited thereto. Herein, the width W1 is, for example, a maximum width of the second opening 125 measured in an extending direction of the local cross-sectional view, and the extending direction of the local cross-sectional view is perpendicular to the normal direction of the base layer 110.

The second bank portion 122 may be separated from the first bank portion 121 through the second opening 125. The second bank portion 122 may be closer to the cutting line 114 of the base layer 110 than the first bank portion 121. A width W2 of the second bank portion 122 may be greater than 0 nm (i.e., W2 > 0 nm), for example, but it is not limited thereto. Herein, the width W2 is, for example, a maximum width of the second bank portion 122 measured in the extending direction of the local cross-sectional view. Besides, in this embodiment, a material of the bank layer 120 includes a light-absorbing material and/or a reflective material, such as a photoresist material (e.g., acrylic resin or siloxane), black resin, a metal material, other suitable materials, or a combination of the foregoing materials.

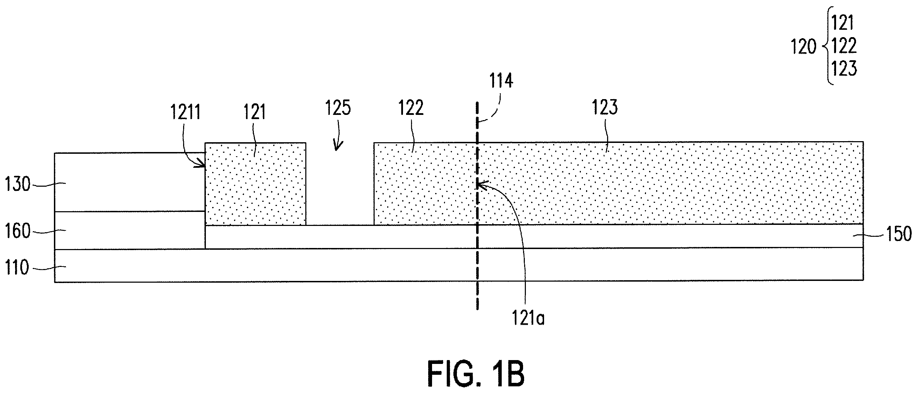

Next, with reference to FIG. 1B, a color filtering layer 160 is formed in the opening 151, and the wavelength conversion unit 130 is formed in the first opening 124. In this embodiment, the color filtering layer 160 may cover the portion of the base layer 110 exposed by the opening 151. The color filtering layer 160 may be disposed between wavelength conversion unit 130 and the base layer 110. The color filtering layer 160 may include a red filtering layer, a green filter layer, a blue filtering layer, or other suitable color filtering layers, but it is not limited thereto. The color filtering layer 160 may be formed in the opening 151 through, for example, a yellow photolithography process or an ink-jet printing (IJP) process, but it is not limited thereto.

Besides, in this embodiment, the wavelength conversion unit 130 may cover the color filtering layer 160. The wavelength conversion unit 130 is adjacent to the side 1211 of the first bank portion 121 away from the edge 111. The wavelength conversion unit 130 may include quantum dots, fluorescence, phosphorescence, other suitable materials, or a combination of the foregoing materials, but it is not limited thereto. The wavelength conversion unit 130 may be configured to cover a first light ray provided by a light-emitting unit (not shown) into a second light ray. The first light ray has a first peak wavelength, the second light ray has a second peak wavelength, and the first peak wavelength is less than the second peak wavelength. The wavelength conversion unit 130 may be formed in the first opening 124 through, for example, a yellow photolithography process or an ink-jet printing process, but it is not limited thereto.

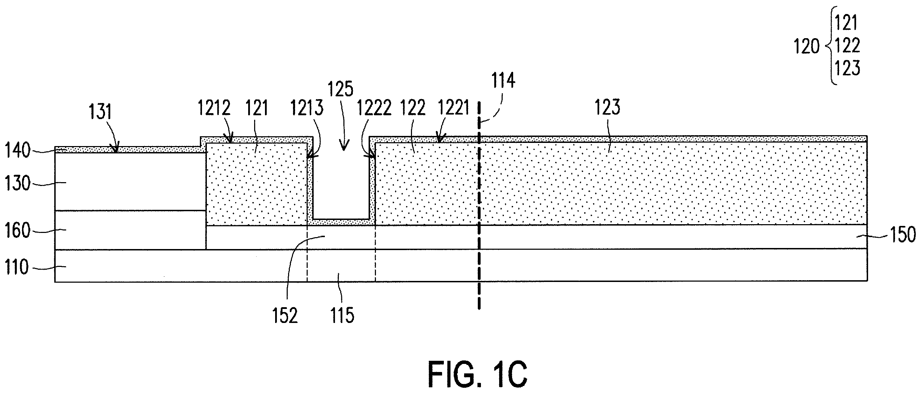

Next, with reference to FIG. 1C, the first encapsulating layer 140 is formed on the bank layer 120, the wavelength conversion unit 130, and the portion 115 of the base layer 110 corresponding to the second opening 125 together through an once processing method. To be specific, in this embodiment, the first encapsulating layer 140 contacts and covers a top surface 131 of the wavelength conversion unit 130, the first encapsulating layer 140 may contact and cover a top surface 1212 and a side surface 1213 of the first bank portion 121, and the first encapsulating layer 140 may contact and cover a top surface 1221 and a side surface 1222 of the second bank portion 122. Herein, the top surface 131 of the wavelength conversion unit 130 is the surface of the wavelength conversion unit 130 away from the base layer 110, the top surface 1212 of the first bank portion 121 is the surface of the first bank portion 121 away from the base layer 110, and the top surface 1221 of the second bank portion 122 is the surface of the second bank portion 122 away from the base layer 110. The side surface 1213 of the first bank portion 121 is the surface of the first bank portion 121 adjacent to the second opening 125, and the side surface 1222 of the second bank portion 122 is the surface of the second bank portion 122 adjacent to the second opening 125.

In this embodiment, through once processing, the first encapsulating layer 140 featuring a water-resist effect may contact and cover the top surface 1212 and the side surface 1213 of the first bank portion 121 of the bank layer 120 together, and in this way, infiltration caused water vapor passing through the first bank portion 121 may be accordingly reduced. In turn, reliability of the optical substrate 100 provided by this embodiment may be improved, especially for the optical substrate 100 including the wavelength conversion unit 130 that is susceptible to failure as affected by external water vapor or for a spliced display (zero border tiling display) including the optical substrate 100, but it is not limited thereto.

In this embodiment, since the second opening 125 of the bank layer 120, the portion 152 of the black matrix layer 150, and the portion 115 of the base layer 110 may overlap with one another in the normal direction of the base layer 110, the first encapsulating layer 140 contacts and covers the portion 152 of the black matrix layer 150 through the second opening 125. In this embodiment, a material of the first encapsulating layer 140 may include but not limited to silicon nitride (SiNₓ), silicon oxide (SiOₓ), silicon oxynitride (SiOₓN_{y}), and aluminum oxide (Al₂O₃), other transparent inorganic compounds having a water-resist effect, or a combination of the foregoing. A manufacturing method of the first encapsulating layer 140 may include but not limited to chemical vapor deposition (CVD), atomic layer deposition (ALD), spin coating, spray coating, physical vapor deposition (PVD), ink-jet printing, or other suitable coating processes.

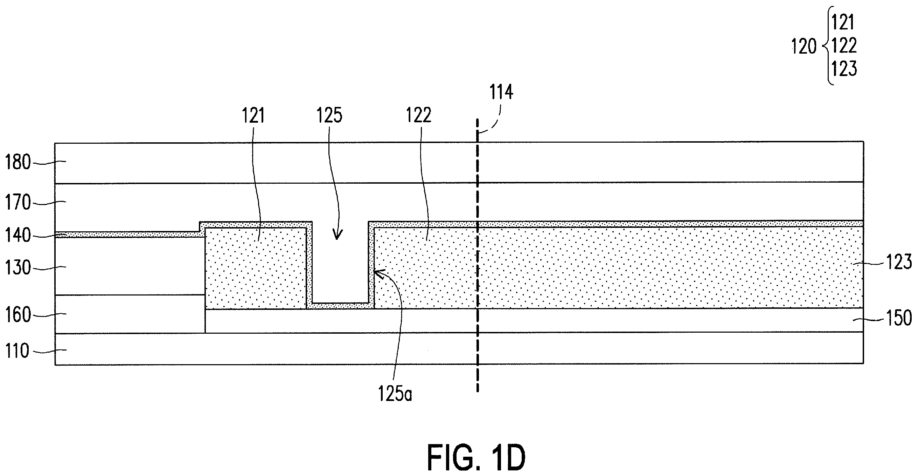

Next, with reference to FIG. 1D and FIG. 1E together, after an adhesive layer 170 is formed on the first encapsulating layer 140 and a driver substrate 180 is disposed on the adhesive layer 170, the base layer 110, the black matrix layer 150, the bank layer 120, the first encapsulating layer 140, the adhesive layer 170, and the driver substrate 180 are cut along the cutting line 114. Herein, the cutting line 114 is adjacent to a side 125a of the second opening 125 away from the first opening 124, and the cutting line 114 does not overlap with the second opening 125. In this embodiment, a material of the adhesive layer 170 may include but not limited to an optically clear adhesive (OCA), optical clear resin (OCR), other suitable transparent materials, or a combination of the foregoing materials. In this embodiment, the driver substrate 180 may include but not limited to a driver circuit (not shown) such as a transistor (TFT), a scan line, and a data line and a light emitting unit (not shown). Besides, in other embodiments, before the adhesive layer 170 is formed on the first encapsulating layer 140 and the driver substrate 180 is disposed on the adhesive layer 170, the base layer 110, the black matrix layer 150, the bank layer 120, and the first encapsulating layer 140 may be cut along the cutting line 114. In the disclosure, the cutting may be performed by a laser, a wheel cutter, or an etching process, but it is not limited thereto.

Next, with reference to 1E, after the base layer 110, the black matrix layer 150, the bank layer 120, the first encapsulating layer 140, the adhesive layer 170, and the driver substrate 180 are cut along the cutting line 114, the second encapsulating layer 142 may be additionally formed on the edge 111 which is exposed after the base layer 110 is cut, on the edge 153 which is exposed after the black matrix layer 150 is cut, on the edge 1223 which is exposed after the second bank portion 122 is cut, and on the edge 143 which is exposed after the first encapsulating layer 140 is cut as needed. In this way, the second encapsulating layer 142 may cover the edge 111 of the base layer 110, the edge 153 of the black matrix layer 150, the edge 1223 of the second bank portion 122, and the edge 143 of the first encapsulating layer 140. Accordingly, the second encapsulating layer 142 featuring the water-resist effect may also contact and cover the edge 153 which is exposed after the black matrix layer 150 is cut, so that infiltration caused by water vapor passing through the black matrix layer 150 is reduced, and the reliability of the optical substrate 100 provided by this embodiment is further improved.

However, since a thickness (e.g., approximately 1 micrometer) of the black matrix layer 150 is much smaller than a thickness (e.g., approximately 8 micrometers) of the second bank portion 122, compared with the second bank portion 122, the probability of infiltration of water vapor through the black matrix layer 150 is lower. Therefore, in some embodiments, the second encapsulating layer is not required to be additionally provided to cover the edge (not shown) which is exposed after the black matrix layer is cut. Herein, the thickness of the black matrix layer 150 is, for example, a maximum thickness of the black matrix layer 150 measured in the normal direction of the base layer 110, and the thickness of the second bank portion 122 is, for example, a maximum thickness of the second bank portion 122 measured in the normal direction of the base layer 110.

In this embodiment, the first encapsulating layer 140 may contact the second encapsulating layer 142. The second bank portion 122 of the bank layer 120 may be closer to the edge 111 of the base layer 110 than the first bank portion 121. Manufacturing of the optical substrate 100 of this embodiment is completed so far.

Other embodiments are described for illustration in the following. It should be noted that the reference numerals and part of the content in the previous embodiment are used in the following embodiments, in which identical reference numerals indicate identical or similar components, and repeated description of the same technical content is omitted. Please refer to the descriptions of the previous embodiment for the omitted part, which will not be repeated hereinafter.

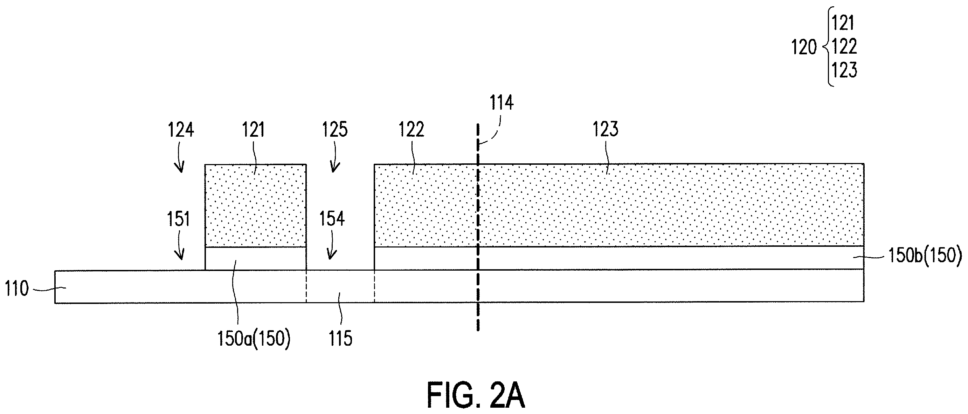

FIG. 2A to FIG. 2C are local cross-sectional schematic views of a manufacturing method of an optical substrate according to a second comparative example not falling under the claimed invention. The second comparative example shown in FIG. 2A to FIG. 2C is similar to the first embodiment shown in FIG. 1A to FIG. 1E, and therefore, the same components are denoted by the same reference numerals, and details thereof are not repeated herein. The difference between the second comparative example shown in FIG. 2A to FIG. 2C and the first embodiment shown in FIG. 1A to FIG. 1E is that the first encapsulating layer 140 may further contact and cover a side surface 150a1 of a first black matrix layer 150a in an optical substrate 100a provided by this embodiment.

To be specific, with reference to FIG. 2A, a manufacturing method similar to the abovementioned manufacturing method of FIG. 1A is adopted for manufacturing. However, the difference between the manufacturing method provided by this comparative example and the manufacturing method provided by FIG. 1A is that in the manufacturing method provided by this embodiment, the following step is further included. After the black matrix layer 150 is formed on the base layer 110, the black matrix layer 150 is patterned to form a third opening 154, the first black matrix layer 150a, and a second black matrix layer 150b. Herein, the second opening 125 may be connected to and overlap with the third opening 154, so that the second opening 125 and the third opening 154 may expose the portion 115 of the base layer 110. In other words, the portion 115 of the base layer 110 is not covered by the bank layer 120 and the black matrix layer 150. The first black matrix layer 150a may be separated from the second black matrix layer 150b through the third opening 154. The second black matrix layer 150b may be closer to the cutting line 114 of the base layer 110 than the first black matrix layer 150a. In this comparative example patterning of the black matrix layer 150 may be executed through a yellow photolithography process or a printing process, but it is not limited thereto.

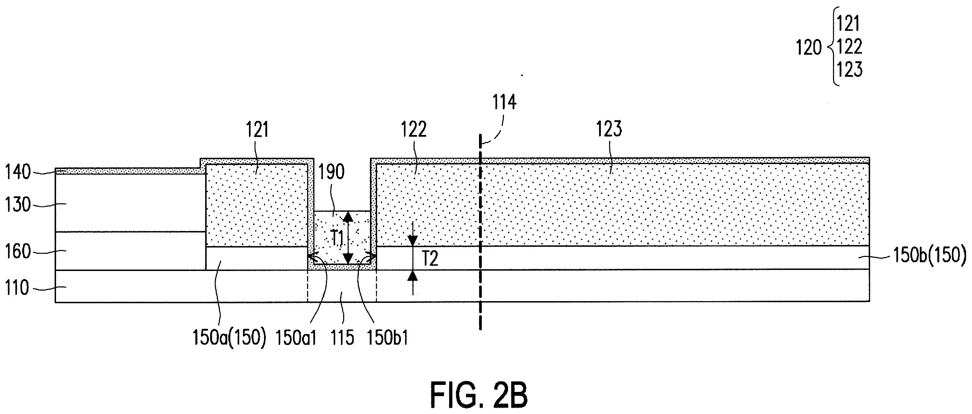

Next, with reference to FIG. 2B, a manufacturing method similar to the abovementioned manufacturing method of FIG. 1B to FIG. 1C is adopted for manufacturing. However, the difference between the manufacturing method provided by this comparative example and the manufacturing method provided by FIG. 1B to FIG. 1C is that the first encapsulating layer 140 provided by this comparative example may further contact and cover the side surface 150a1 of the first black matrix layer 150a, the first encapsulating layer 140 may further contact and cover a side surface 150b1 of the second black matrix layer 150b, and the first encapsulating layer 140 may further contact and cover the portion 115 of the base layer 110 through the second opening 125 and the third opening 154. Herein, the side surface 150a1 of the first black matrix layer 150a is the surface of the first black matrix layer 150a adjacent to the third opening 154, and the side surface 150b1 of the second black matrix layer 150b is the surface of the second black matrix layer 150b adjacent to the third opening 154.

In this comparative example, since the first encapsulating layer 140 featuring the water-resist effect may further contact and cover the side surface 150a1 of the first black matrix layer 150a, infiltration caused by water vapor passing through the first black matrix layer 150a is reduced, and the reliability of the optical substrate 100a provided by this embodiment is further improved.

In addition, the manufacturing method provided by this comparative example further includes the following step. After the first encapsulating layer 140 is formed on the bank layer 120, the wavelength conversion unit 130, and the portion 115 of the base layer 110, a light absorbing unit 190 is formed in the third opening 154 of the black matrix layer 150. The light absorbing unit 190 may be formed in the third opening 154 through, for example, a yellow photolithography process or an ink-jet printing (IJP) process. Herein, the light absorbing unit 190 may be disposed on the portion 115 of the base layer 110, and the light absorbing unit 190 may be disposed between the first bank portion 121 and the second bank portion 122 of the bank layer 120. Further, the first bank portion 121 may be disposed between the light absorbing unit 190 and the wavelength conversion unit 130. In this embodiment, a thickness T1 of the light absorbing unit 190 may be, for example, greater than or equal to a thickness T2 of the black matrix layer 150 (i.e., T1 ≧ T2), but it is not limited thereto. Herein, the thickness T1 is, for example, a maximum thickness of the light absorbing unit 190 measured in the normal direction of the base layer 110, and the thickness T2 is, for example, a maximum thickness of the black matrix layer 150 measured in the normal direction of the base layer 110. A material of the light absorbing unit 190 may include but not limited to a light-absorbing material such as black resin, black ink, a black adhesive, other suitable light-absorbing materials, or a combination of the foregoing materials.

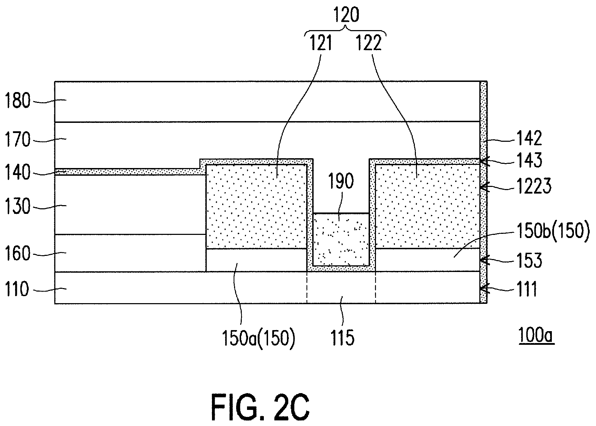

Next, with reference to FIG. 2C, similar to the manufacturing method shown in FIG. 1D to FIG. 1E, the adhesive layer 170 is formed on the first encapsulating layer 140, and the driver substrate 180 is disposed on the adhesive layer 170. The base layer 110, the black matrix layer 150, the bank layer 120, the first encapsulating layer 140, the adhesive layer 170, and the driver substrate 180 are cut along the cutting line 114, and the second encapsulating layer 142 is additionally formed as needed, so that the second encapsulating layer 142 may contact and cover the edge 111 which is exposed after the base layer 110 is cut, the edge 153 which is exposed after the second black matrix layer 150b is cut, the edge 1223 which is exposed after the second bank portion 122 is cut, and the edge 143 which is exposed after the first encapsulating layer 140 is cut. However, in some embodiments, the second encapsulating layer 142 is not required to be additionally disposed. Manufacturing of the optical substrate 100a of this embodiment is completed so far. Besides, in other embodiments, before the adhesive layer 170 is formed on the first encapsulating layer 140 and the driver substrate 180 is disposed on the adhesive layer 170, the base layer 110, the black matrix layer 150, the bank layer 120, the first encapsulating layer 140 may be cut along the cutting line 114.

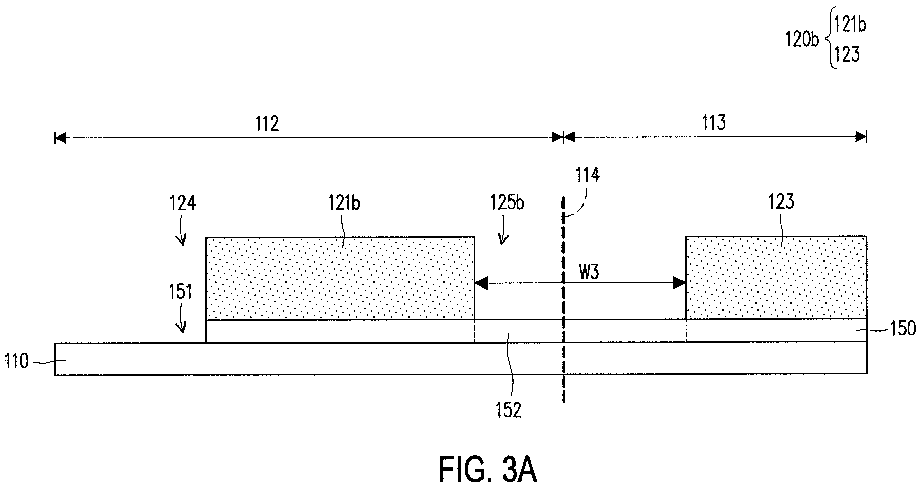

FIG. 3A to FIG. 3C are local cross-sectional schematic views of a manufacturing method of an optical substrate according to a third embodiment of the disclosure. The third embodiment shown in FIG. 3A to FIG. 3C is similar to the first embodiment shown in FIG. 1A to FIG. 1E, and therefore, the same components are denoted by the same reference numerals, and details thereof are not repeated herein. The difference between the third embodiment shown in FIG. 3A to FIG. 3C and the first embodiment shown in FIG. 1A to FIG. 1E is that a bank layer 120b does not include a second bank portion and a position of a second opening 125b of the bank layer 120b is different in an manufacturing method of an optical substrate 100b provided by this embodiment.

To be specific, with reference to FIG. 3A, a manufacturing method similar to the abovementioned manufacturing method of FIG. 1A is adopted for manufacturing. However, the difference between the manufacturing method provided by this embodiment and the manufacturing method provided by FIG. 1A is that the second opening 125b of the bank layer 120b is disposed at the junction between the active region 112 and the frame region 113 when the bank layer 120b is formed on the black matrix layer 150. That is, the second opening 125b is disposed between a first bank portion 121b and the third bank portion 123, and the third bank portion 123 may be separated from the first bank portion 121b through the second opening 125b. In this embodiment, a width W3 of the second opening 125b may be greater than or equal to 3 nm (i.e., W3 ≧ 3 nm), for example, but it is not limited thereto. Herein, the width W3 is, for example, a maximum width of the second opening 125b measured in the extending direction of the local cross-sectional view. In addition, in this embodiment, in the normal direction of the base layer 110, the cutting line 114 may overlap with the second opening 125b.

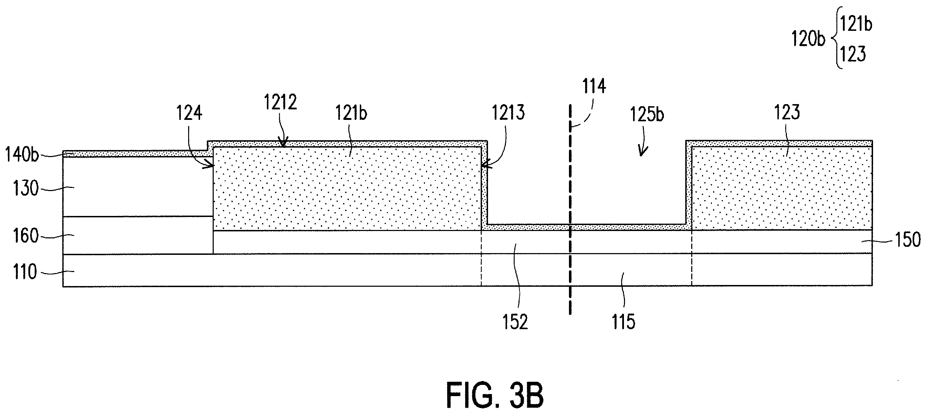

Next, with reference to FIG. 3B, similar to the manufacturing method shown in FIG. 1B to FIG. 1C, the color filtering layer 160 is formed in the opening 151, the wavelength conversion unit 130 is formed in the first opening 124, and a first encapsulating layer 140b is formed on the bank layer 120b, the wavelength conversion unit 130, and the portion 152 of the black matrix layer 150. Accordingly, the first encapsulating layer 140b featuring the water-resist effect contacts and covers the top surface 1212 and the side surface 1213 of the first bank portion 121b of the bank layer 120 together, so that infiltration caused by water vapor passing through the first bank portion 121b is reduced, and the reliability of the optical substrate 100b provided by this embodiment may be improved.

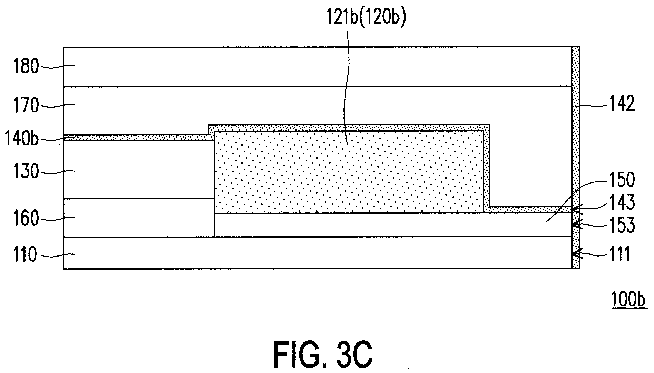

Next, with reference to FIG. 3C, similar to the manufacturing method shown in FIG. 1D to FIG. 1E, the adhesive layer 170 is formed on the first encapsulating layer 140b, and the driver substrate 180 is disposed on the adhesive layer 170. After the base layer 110, the black matrix layer 150, the first encapsulating layer 140b, the adhesive layer 170, and the driver substrate 180 are cut along the cutting line 114, the second encapsulating layer 142 may also be additionally formed on the edge 111 which is exposed after the base layer 110 is cut, on the edge 153 which is exposed after the black matrix layer 150 is cut, and on the edge 143 which is exposed after the first encapsulating layer 140b is cut as needed. Herein, the second encapsulating layer 142 may also contact and cover the edge 153 of the black matrix layer 150, so that infiltration caused by water vapor passing through the black matrix layer 150 is also reduced, and the reliability of the optical substrate 100b provided by this embodiment is further improved. Manufacturing of the optical substrate 100b of this embodiment is completed so far. Besides, in other embodiments, before the adhesive layer 170 is formed on the first encapsulating layer 140 and the driver substrate 180 is disposed on the adhesive layer 170, the base layer 110, the black matrix layer 150, and the first encapsulating layer 140b may be cut along the cutting line 114.

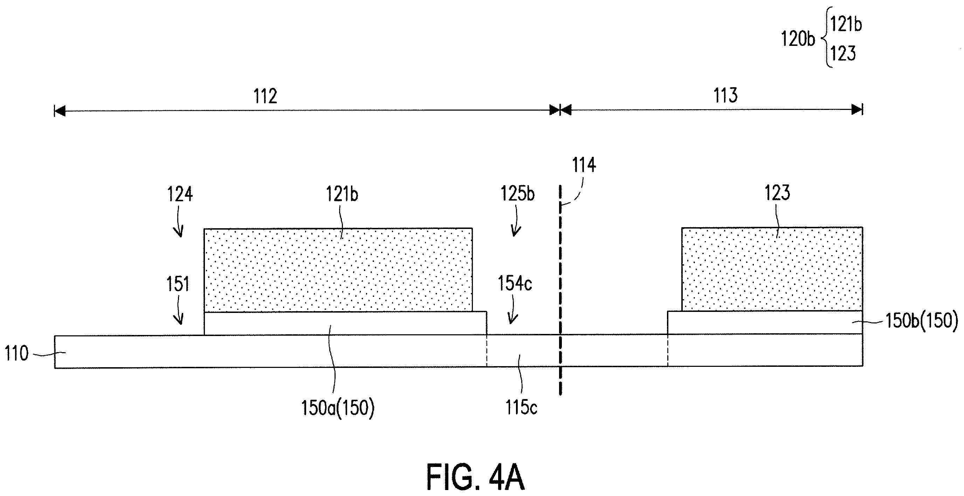

FIG. 4A to FIG. 4C are local cross-sectional schematic views of a manufacturing method of an optical substrate according to a fourth embodiment of the disclosure. The fourth embodiment shown in FIG. 4A to FIG. 4C is similar to the third embodiment shown in FIG. 3A to FIG. 3C, and therefore, the same components are denoted by the same reference numerals, and details thereof are not repeated herein. The difference between the fourth embodiment shown in FIG. 4A to FIG. 4C and the third embodiment shown in FIG. 3A to FIG. 3C is that a first encapsulating layer 140c may further contact and cover the side surface 150a1 of the first black matrix layer 150a in an optical substrate 100c provided by this embodiment.

To be specific, with reference to FIG. 4A, a manufacturing method similar to the abovementioned manufacturing method of FIG. 3A is adopted for manufacturing. However, the difference between the manufacturing method provided by this embodiment and the manufacturing method provided by FIG. 3A is that in the manufacturing method provided by this embodiment, the following step is further included. After the black matrix layer 150 is formed on the base layer 110, the black matrix layer 150 is patterned to form a third opening 154c, the first black matrix layer 150a, and a second black matrix layer 150b. Herein, the second opening 125b may be connected to and overlap with the third opening 154c, so that the second opening 125 and the third opening 154c may expose a portion 115c of the base layer 110, and the portion 115c of the base layer 110 is not covered by the black matrix layer 150. The first black matrix layer 150a may be separated from the second black matrix layer 150b through the third opening 154c. The first black matrix layer 150a is disposed in the active region 112, and the second black matrix layer 150b is disposed in the frame region 113.

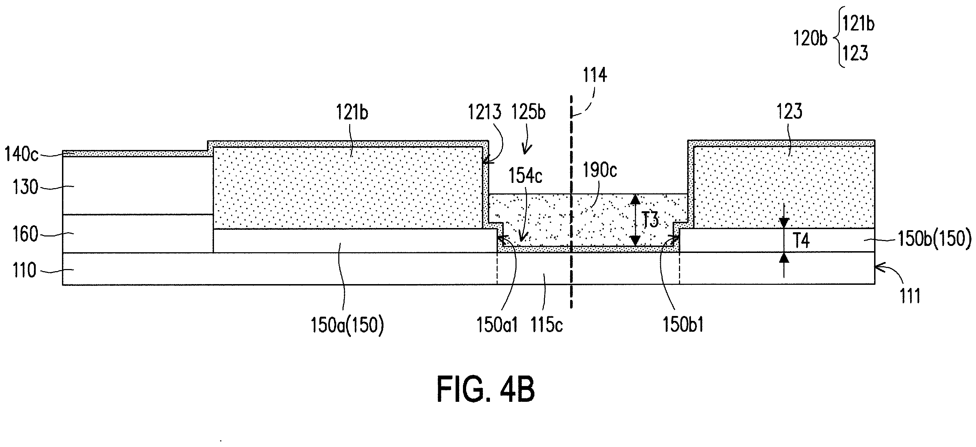

Next, with reference to FIG. 4B, a manufacturing method similar to the abovementioned manufacturing method of FIG. 3B is adopted for manufacturing. However, the difference between the manufacturing method provided by this embodiment and the manufacturing method provided by FIG. 3B is that the first encapsulating layer 140 provided by this embodiment may further contact and cover the side surface 150a1 of the first black matrix layer 150a, the first encapsulating layer 140 may further contact and cover the side surface 150b1 of the second black matrix layer 150b, and the first encapsulating layer 140c may further contact and cover the portion 115c of the base layer 110 through the second opening 125b and the third opening 154c. Herein, the side surface 150a1 of the first black matrix layer 150a is the surface of the first black matrix layer 150a adjacent to the third opening 154c, and the side surface 150b1 of the second black matrix layer 150b is the surface of the second black matrix layer 150b adjacent to the third opening 154c.

In this embodiment, since the first encapsulating layer 140 featuring the water-resist effect may further contact and cover the side surface 150a1 of the first black matrix layer 150a, infiltration caused by water vapor passing through the first black matrix layer 150a is reduced, and the reliability of the optical substrate 100c provided by this embodiment is further improved.

In addition, the manufacturing method provided by this embodiment further includes the following step. After the first encapsulating layer 140c is formed on the bank layer 120b, the wavelength conversion unit 130, and the portion 115c of the base layer 110, a light absorbing unit 190c is formed in the third opening 154c of the black matrix layer 150. Herein, the light absorbing unit 190c may be disposed on the portion 115c of the base layer 110, and the light absorbing unit 190c may be disposed between the first bank portion 121b and the third bank portion 123 of the bank layer 120. The light absorbing unit 190c may be disposed at a side of the first bank portion 121b adjacent to the edge 111. Further, the first bank portion 121b may be disposed between the light absorbing unit 190c and the wavelength conversion unit 130. In this embodiment, a thickness T3 of the light absorbing unit 190c may be, for example, greater than or equal to a thickness T4 of the black matrix layer 150 (i.e., T3 ≧ T4), but it is not limited thereto. Herein, the thickness T3 is, for example, a maximum thickness of the light absorbing unit 190c measured in the normal direction of the base layer 110, and the thickness T4 is, for example, a maximum thickness of the black matrix layer 150 measured in the normal direction of the base layer 110.

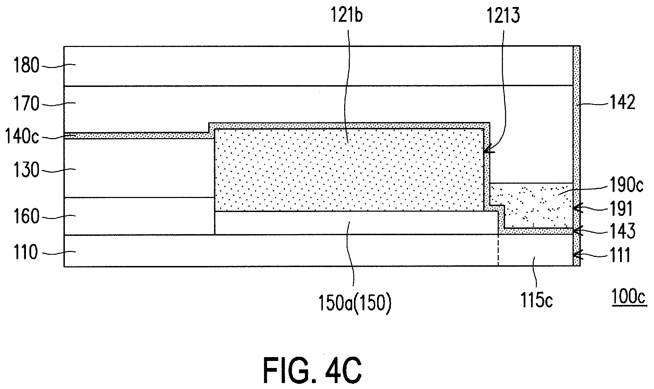

Next, with reference to FIG. 4C, similar to the manufacturing method shown in FIG. 3C, the adhesive layer 170 is formed on the first encapsulating layer 140c, and the driver substrate 180 is disposed on the adhesive layer 170. The base layer 110, the first encapsulating layer 140c, the light absorbing unit 190c, the adhesive layer 170, and the driver substrate 180 are cut along the cutting line 114, and the second encapsulating layer 142 is additionally formed as needed, so that the second encapsulating layer 142 may contact and cover the edge 111 which is exposed after the base layer 110 is cut, the edge 143 which is exposed after the first encapsulating layer 140c is cut, and the edge 191 which is exposed after the light absorbing unit 190c is cut. However, in some embodiments, the second encapsulating layer 142 is not required to be additionally disposed. In this embodiment, the second encapsulating layer 142 may contact the first encapsulating layer 140. Manufacturing of the optical substrate 100c of this embodiment is completed so far. Besides, in other embodiments, before the adhesive layer 170 is formed on the first encapsulating layer 140 and the driver substrate 180 is disposed on the adhesive layer 170, the base layer 110, the first encapsulating layer 140c, and the light absorbing unit 190c may be cut along the cutting line 114.

In view of the foregoing, in the optical substrate and the manufacturing method thereof provided by the embodiments of the disclosure, through once processing, the first encapsulating layer may contact and cover the top surface and the side surface of the first bank portion of the bank layer together, and in this way, infiltration caused water vapor passing through the first bank portion may be accordingly reduced. In turn, reliability of the optical substrate provided by the embodiments of the disclosure may be improved, especially for the optical substrate including the wavelength conversion unit that is susceptible to failure as affected by external water vapor or for a spliced display (zero border tiling display) including the optical substrate, but it is not limited thereto. In addition, in the embodiments of the disclosure, the second encapsulating layer may be additionally disposed as needed, and the second encapsulating layer may be arranged to contact and cover the edge of the black matrix layer. In this way, infiltration caused by water vapor passing through the black matrix layer may be reduced, and the reliability of the optical substrate may thus be improved. Further, in some embodiments of the disclosure, since the first encapsulating layer may further contact and cover the side surface of the first black matrix layer, infiltration caused by water vapor passing through the first black matrix layer is reduced, and the reliability of the optical substrate is therefore further improved.

## Claims

1. An optical substrate (100, 100b, 100c), comprising:
a base layer (110);
a bank layer (120, 120b), disposed on the base layer (110), comprising a first bank portion (121, 121b) separated from an edge (111) of the base layer (110), and having a first opening (124) and a second opening (125, 125b);
a black matrix layer (150) disposed between base layer (110) and the bank layer (120, 120b);
a wavelength conversion unit (130), disposed on the base layer (110), adjacent to a side (1211) of the first bank portion (121, 121b) away from the edge (111), wherein the wavelength conversion unit is disposed in the first opening, and the wavelength conversion unit is not disposed in the second opening; and
a first encapsulating layer (140, 140b, 140c), disposed on bank layer (120, 120b), the wavelength conversion unit (130), and a portion (115, 115c) of the base layer (110) not covered by the bank layer (120, 120b) and the wavelength conversion unit (130);
a driver substrate (180) disposed opposite to the base layer (110);
an adhesive layer (170) disposed between the driver substrate (180) and the first encapsulating layer (140, 140b, 140c),
wherein the optical substrate is **characterized in that**
the first encapsulating layer contacts a top surface (1212) and a side surface (1213) of the first bank portion, and the first encapsulating layer contacts a top surface (131) of the wavelength conversion unit, and the side surface (1213) of the first bank portion (121, 121b) is adjacent to the second opening (125, 125b),
a material of the bank layer comprises a light-absorbing material and/or a reflective material, and a material of the first encapsulating layer comprises transparent inorganic compounds having a water-resist effect,
the portion of the base layer corresponds to and overlaps the second opening,
a portion (152) of the black matrix layer (150) is not covered by the bank layer (120, 120b), and the first encapsulating layer (140, 140b, 140c) contacts the portion (152) of the black matrix layer (150) and the adhesive layer (170).

2. The optical substrate (100) according to claim 1, wherein the bank layer (120) further comprises a second bank portion (122), wherein the second bank portion (122) is separated from the first bank portion (121), and the second bank portion (122) is closer to the edge (111) of the base layer (110) than the first bank portion (121).

3. The optical substrate (100c) according to claim 1, further comprising:
a light absorbing unit (190c), disposed at a side (1213) of the first bank portion (121, 121b) adjacent to the edge (111).

4. The optical substrate (100c) according to claim 1, wherein a portion (115c) of the base layer (110) is not covered by the black matrix layer (150), and the first encapsulating layer (140b) contacts the portion (115c) of the base layer (110).

5. The optical substrate (100c) according to claim 4, further comprising:
a light absorbing unit (190c), disposed on the portion (115c) of the base layer (110).

6. A manufacturing method of an optical substrate (100, 100b, 100c), comprising:
providing a base layer (110);
forming a black matrix layer (150) on the base layer (110);
forming a bank layer (120, 120b) on the black matrix layer (150), wherein the bank layer (120, 120b) has a first opening (124) and a second opening (125, 125b);
forming a wavelength conversion unit (130) in the first opening (124); and
forming a first encapsulating layer (140, 140b, 140c) on the bank layer (120, 120b), the wavelength conversion unit (130), and a portion (115, 115c) of the base layer (110) corresponding to the second opening (125, 125b);
providing a driver substrate (180);
forming an adhesive layer between the driver substrate (180) and the first encapsulating layer (140, 140b, 140c),
wherein the manufacturing method is **characterized in that**
the first encapsulating layer contacts a top surface (1212) and a side surface (1213) of the first bank portion, and the first encapsulating layer contacts a top surface (131) of the wavelength conversion unit, and the side surface (1213) of the first bank portion (121, 121b) is adjacent to the second opening (125, 125b),
a material of the bank layer comprises a light-absorbing material and/or a reflective material, and a material of the first encapsulating layer comprises transparent inorganic compounds having a water-resist effect,
the wavelength conversion unit is not disposed in the second opening,
the portion of the base layer corresponds to and overlaps the second opening, and the portion of the base layer is not covered by the bank layer and the wavelength conversion unit, and
a portion (152) of the black matrix layer (150) is not covered by the bank layer (120, 120b), and the first encapsulating layer (140, 140b, 140c) contacts the portion (152) of the black matrix layer (150) and the adhesive layer (170).

7. The manufacturing method according to claim 6, wherein the first encapsulating layer (140, 140b, 140c) contacts the black matrix layer (150) through the second opening (125, 125b).

8. The manufacturing method according to claim 6, further comprising:
patterning the black matrix layer (150) to form a third opening (154c), wherein the second opening (125b) overlaps the third opening (154c), and the first encapsulating layer (140b) contacts the base layer (110) through the second opening (125b) and the third opening (154c).

9. The manufacturing method according to claim 8, further comprising:
forming a light absorbing unit (190c) in the third opening (154c).

10. The manufacturing method according to claim 6, further comprising:
cutting the base layer (110) and the first encapsulating layer (140b, 140c) along a cutting line (114), wherein the cutting line (114) overlaps the second opening (125b).

11. The manufacturing method according to claim 6, further comprising:
cutting the base layer (110), the bank layer (120), and the first encapsulating layer (140) along a cutting line (114), wherein the cutting line (114) is adjacent to a side (125a) of the second opening (125) away from the first opening (124).

## Patentansprüche

1. Optisches Substrat (100, 100b, 100c), umfassend:
eine Basisschicht (110);
eine auf der Basisschicht (110) angeordnete Bankschicht (120, 120b), die einen ersten Bankabschnitt (121, 121b) umfasst, der von einem Rand (111) der Basisschicht (110) getrennt ist und eine erste Öffnung (124) sowie eine zweite Öffnung (125, 125b) aufweist;
eine Black-Matrix-Schicht (150), die zwischen der Basisschicht (110) und der Bankschicht (120, 120b) angeordnet ist;
eine Wellenlängenumwandlungseinheit (130), die auf der Basisschicht (110) benachbart zu einer Seite (1211) des ersten Bankabschnitts (121, 121b) angeordnet ist, die von dem Rand (111) entfernt ist, wobei die Wellenlängenumwandlungseinheit in der ersten Öffnung angeordnet ist und die Wellenlängenumwandlungseinheit nicht in der zweiten Öffnung angeordnet ist; und
eine erste Verkapselungsschicht (140, 140b, 140c), die auf der Bankschicht (120, 120b), der Wellenlängenumwandlungseinheit (130) und einem Abschnitt (115, 115c) der Basisschicht (110) angeordnet ist, der nicht von der Bankschicht (120, 120b) und der Wellenlängenumwandlungseinheit (130) bedeckt ist;
ein Treibersubstrat (180), das gegenüber der Basisschicht (110) angeordnet ist;
eine Haftschicht (170), die zwischen dem Treibersubstrat (180) und der ersten Verkapselungsschicht (140, 140b, 140c) angeordnet ist,
wobei das optische Substrat **dadurch gekennzeichnet ist, dass**
die erste Verkapselungsschicht eine Oberseite (1212) und eine Seitenfläche (1213) des ersten Bankabschnitts kontaktiert, und die erste Verkapselungsschicht eine Oberseite (131) der Wellenlängenumwandlungseinheit kontaktiert, und die Seitenfläche (1213) des ersten Bankabschnitts (121, 121b) an der zweiten Öffnung (125, 125b) angrenzt,
ein Material der Bankschicht ein lichtabsorbierendes Material und / oder ein reflektierendes Material umfasst, und ein Material der ersten Verkapselungsschicht transparente anorganische Verbindungen mit einer wasserabweisenden Wirkung umfasst,
der Abschnitt der Basisschicht der zweiten Öffnung entspricht und diese überlappt,
ein Abschnitt (152) der Black-Matrix-Schicht (150) nicht von der Bankschicht (120, 120b) bedeckt ist und die erste Verkapselungsschicht (140, 140b, 140c) den Abschnitt (152) der Black-Matrix-Schicht (150) und die Haftschicht (170) kontaktiert.

2. Optisches Substrat (100) nach Anspruch 1, wobei die Bankschicht (120) ferner einen zweiten Bankabschnitt (122) umfasst, wobei der zweite Bankabschnitt (122) von dem ersten Bankabschnitt (121) getrennt ist und der zweite Bankabschnitt (122) näher an dem Rand (111) der Basisschicht (110) liegt als der erste Bankabschnitt (121).

3. Optisches Substrat (100c) nach Anspruch 1, ferner umfassend:
eine lichtabsorbierende Einheit (190c), die an einer Seite (1213) des ersten Bankabschnitts (121, 121b) an der Kante (111) angrenzt.

4. Optisches Substrat (100c) nach Anspruch 1, wobei ein Abschnitt (115c) der Basisschicht (110) nicht von der Black-Matrix-Schicht (150) bedeckt ist und die erste Verkapselungsschicht (140b) den Abschnitt (115c) der Basisschicht (110) kontaktiert.

5. Optisches Substrat (100c) nach Anspruch 4, ferner umfassend:
eine lichtabsorbierende Einheit (190c), die auf dem Abschnitt (115c) der Basisschicht (110) angeordnet ist.

6. Verfahren zur Herstellung eines optischen Substrats (100, 100b, 100c), umfassend:
Bereitstellen einer Basisschicht (110);
Bilden einer Black-Matrix-Schicht (150) auf der Basisschicht (110);
Bilden einer Bankschicht (120, 120b) auf der Black-Matrix-Schicht (150), wobei die Bankschicht (120, 120b) eine erste Öffnung (124) und eine zweite Öffnung (125, 125b) aufweist;
Bilden einer Wellenlängenumwandlungseinheit (130) in der ersten Öffnung (124); und
Bilden einer ersten Verkapselungsschicht (140, 140b, 140c) auf der Bankschicht (120, 120b), der Wellenlängenumwandlungseinheit (130) und einem Abschnitt (115, 115c) der Basisschicht (110), der der zweiten Öffnung (125, 125b) entspricht;
Bereitstellen eines Treibersubstrats (180);
Bilden einer Haftschicht zwischen dem Treibersubstrat (180) und der ersten Verkapselungsschicht (140, 140b, 140c),
wobei das Herstellungsverfahren **dadurch gekennzeichnet ist, dass**
die erste Verkapselungsschicht eine Oberseite (1212) und eine Seitenfläche (1213) des ersten Bankabschnitts kontaktiert und die erste Verkapselungsschicht eine Oberseite (131) der Wellenlängenumwandlungseinheit kontaktiert, und die Seitenfläche (1213) des ersten Bankabschnitts (121, 121b) an der zweiten Öffnung (125, 125b) angrenzt,
ein Material der Bankschicht ein lichtabsorbierendes Material und / oder ein reflektierendes Material umfasst, und ein Material der ersten Verkapselungsschicht transparente anorganische Verbindungen mit einer wasserabweisenden Wirkung umfasst,
die Wellenlängenumwandlungseinheit nicht in der zweiten Öffnung angeordnet ist,
der Abschnitt der Basisschicht der zweiten Öffnung entspricht und diese überlappt, und der Abschnitt der Basisschicht nicht von der Bankschicht und der Wellenlängenumwandlungseinheit bedeckt ist, und
ein Abschnitt (152) der Black-Matrix-Schicht (150) nicht von der Bankschicht (120, 120b) bedeckt ist und die erste Verkapselungsschicht (140, 140b, 140c) den Abschnitt (152) der Black-Matrix-Schicht (150) und die Haftschicht (170) kontaktiert.

7. Herstellungsverfahren nach Anspruch 6, wobei die erste Verkapselungsschicht (140, 140b, 140c) die Black-Matrix-Schicht (150) durch die zweite Öffnung (125, 125b) kontaktiert.

8. Herstellungsverfahren nach Anspruch 6, ferner umfassend:
Strukturieren der Black-Matrix-Schicht (150), um eine dritte Öffnung (154c) zu bilden, wobei die zweite Öffnung (125b) die dritte Öffnung (154c) überlappt und die erste Verkapselungsschicht (140b) die Basisschicht (110) durch die zweite Öffnung (125b) und die dritte Öffnung (154c) kontaktiert.

9. Herstellungsverfahren nach Anspruch 8, ferner umfassend:
Bilden einer lichtabsorbierenden Einheit (190c) in der dritten Öffnung (154c).

10. Herstellungsverfahren nach Anspruch 6, ferner umfassend:
Schneiden der Basisschicht (110) und der ersten Verkapselungsschicht (140b, 140c) entlang einer Schnittlinie (114), wobei die Schnittlinie (114) die zweite Öffnung (125b) überlappt.

11. Herstellungsverfahren nach Anspruch 6, ferner umfassend:
Schneiden der Basisschicht (110), der Bankschicht (120) und der ersten Verkapselungsschicht (140) entlang einer Schnittlinie (114), wobei die Schnittlinie (114) an einer Seite (125a) der zweiten Öffnung (125) angrenzt, die von der ersten Öffnung (124) entfernt ist.

## Revendications

1. Substrat optique (100, 100b, 100c), comprenant :
une couche de base (110) ;
une couche de banc (120, 120b), disposée sur la couche de base (110), comprenant une première partie de banc (121, 121b) séparée d'un bord (111) de la couche de base (110), et comportant une première ouverture (124) et une deuxième ouverture (125, 125b);
une couche de matrice noire (150) disposée entre la couche de base (110) et la couche de banc (120, 120b) ;
une unité de conversion de longueur d'onde (130), disposée sur la couche de base (110), adjacente à un côté (1211) de la première partie de banc (121, 121b) éloigné du bord (111), dans laquelle l'unité de conversion de longueur d'onde est disposée dans la première ouverture, et l'unité de conversion de longueur d'onde n'est pas disposée dans la deuxième ouverture ; et
une première couche d'encapsulation (140, 140b, 140c), disposée sur la couche de banc (120, 120b), l'unité de conversion de longueur d'onde (130) et une partie (115, 115c) de la couche de base (110) non recouverte par la couche de banc (120, 120b) et l'unité de conversion de longueur d'onde (130) ;
un substrat de commande (180) disposé en face de la couche de base (110) ;
une couche adhésive (170) disposée entre le substrat de commande (180) et la première couche d'encapsulation (140, 140b, 140c),
dans lequel le substrat optique est **caractérisé en ce que** la première couche d'encapsulation est en contact avec une surface supérieure (1212) et une surface latérale (1213) de la première partie de banc, et la première couche d'encapsulation est en contact avec une surface supérieure (131) de l'unité de conversion de longueur d'onde, et la surface latérale (1213) de la première partie de banc (121, 121b) est adjacente à la deuxième ouverture (125, 125b),
un matériau de la couche de banc comprend un matériau absorbant la lumière et/ou un matériau réfléchissant, et un matériau de la première couche d'encapsulation comprend des composés inorganiques transparents qui ont un effet imperméabilisant,
la partie de la couche de base correspond à la deuxième ouverture et la recouvre,
une partie (152) de la couche de matrice noire (150) n'est pas recouverte par la couche de banc (120, 120b), et la première couche d'encapsulation (140, 140b, 140c) est en contact avec la partie (152) de la couche de matrice noire (150) et la couche adhésive (170).

2. Substrat optique (100) selon la revendication 1, dans lequel la couche de banc (120) comprend en outre une deuxième partie de banc (122), dans lequel la deuxième partie de banc (122) est séparée de la première partie de banc (121), et la deuxième partie de banc (122) est plus proche du bord (111) de la couche de base (110) que la première partie de banc (121).

3. Substrat optique (100c) selon la revendication 1, comprenant en outre :
une unité d'absorption de lumière (190c), disposée sur un côté (1213) de la première partie de banc (121, 121b) adjacent au bord (111).

4. Substrat optique (100c) selon la revendication 1, dans lequel une partie (115c) de la couche de base (110) n'est pas recouverte par la couche de matrice noire (150), et la première couche d'encapsulation (140b) est en contact avec la partie (115c) de la couche de base (110).

5. Substrat optique (100c) selon la revendication 4, comprenant en outre :
une unité d'absorption de lumière (190c), disposée sur la partie (115c) de la couche de base (110).

6. Procédé de fabrication d'un substrat optique (100, 100b, 100c), comprenant :
la fourniture d'une couche de base (110) ;
la formation d'une couche de matrice noire (150) sur la couche de base (110) ;
la formation d'une couche de banc (120, 120b) sur la couche de matrice noire (150),
la couche de banc (120, 120b) comportant une première ouverture (124) et une deuxième ouverture (125, 125b) ; la formation d'une unité de conversion de longueur d'onde (130) dans la première ouverture (124) ; et
former une première couche d'encapsulation (140, 140b, 140c) sur la couche de banc (120, 120b), l'unité de conversion de longueur d'onde (130) et une partie (115, 115c) de la couche de base (110) correspondant à la deuxième ouverture (125, 125b) ; fournir un substrat de commande (180) ;
former une couche adhésive entre le substrat de commande (180) et la première couche d'encapsulation (140, 140b, 140c),
dans lequel le procédé de fabrication est **caractérisé en ce que** la première couche d'encapsulation est en contact avec une surface supérieure (1212) et une surface latérale (1213) de la première partie de banc, et la première couche d'encapsulation est en contact avec une surface supérieure (131) de l'unité de conversion de longueur d'onde, et la surface latérale (1213) de la première partie de banc (121, 121b) est adjacente à la deuxième ouverture (125, 125b),
un matériau de la couche de banc comprend un matériau absorbant la lumière et/ou un matériau réfléchissant, et un matériau de la première couche d'encapsulation comprend des composés inorganiques transparents qui ont un effet imperméabilisant,
l'unité de conversion de longueur d'onde n'est pas disposée dans la deuxième ouverture,
la partie de la couche de base correspond à la deuxième ouverture et la recouvre, et cette partie de la couche de base n'est pas recouverte par la couche de banc et l'unité de conversion de longueur d'onde, et une partie (152) de la couche de matrice noire (150) n'est pas recouverte par la couche de banc (120, 120b), et la première couche d'encapsulation (140, 140b, 140c) est en contact avec la partie (152) de la couche de matrice noire (150) et la couche adhésive (170).

7. Procédé de fabrication selon la revendication 6, dans lequel la première couche d'encapsulation (140, 140b, 140c) est en contact avec la couche de matrice noire (150) à travers la deuxième ouverture (125, 125b).

8. Procédé de fabrication selon la revendication 6, comprenant en outre :
la structuration de la couche de matrice noire (150) pour former une troisième ouverture (154c), dans laquelle la deuxième ouverture (125b) chevauche la troisième ouverture (154c), et la première couche d'encapsulation (140b) est en contact avec la couche de base (110) à travers la deuxième ouverture (125b) et la troisième ouverture (154c).

9. Procédé de fabrication selon la revendication 8, comprenant en outre :la formation d'une unité d'absorption de lumière (190c) dans la troisième ouverture (154c).

10. Procédé de fabrication selon la revendication 6, comprenant en outre :
la découpe de la couche de base (110) et de la première couche d'encapsulation (140b, 140c) le long d'une ligne de découpe (114), dans lequel la ligne de découpe (114) recouvre la deuxième ouverture (125b).

11. Procédé de fabrication selon la revendication 6, comprenant en outre :
la découpe de la couche de base (110), de la couche de banc (120) et de la première couche d'encapsulation (140) le long d'une ligne de découpe (114), dans lequel la ligne de découpe (114) est adjacente à un côté (125a) de la deuxième ouverture (125) opposé à la première ouverture (124).
